# EUROPEAN PATENT SPECIFICATION

(11) **EP 0 655 323 B1**
(45) Date of publication and mention of the grant of the patent: **19.04.2000**
(21) Application number: 94202388.8
(22) Date of filing: 24.11.1989
(51) Int. Cl.: B30B 1/18, B29C 43/34, B29C 45/02, B29C 43/18, B29C 70/72

(54) **Single strip moulding apparatus with means for exerting pressure**
Einzelband-Formvorrichtung mit druckausübenden Mittel
Appareil de moulage pour bande unique avec des moyens pour appliquer de la pression

(43) Date of publication of application: 31.05.1995
(62) Divisional of application: 89203003.2
(73) Proprietor: FICO B.V., 6921 RW Duiven (NL)
(72) Inventor: Venrooij, Johannes Lambertus Gerardus Maria, NL-6921 KG Duiven (NL); Verwoerd, Wouter Bastiaan, NL-6581 RK Malden (NL)
(74) Representative: Van den Heuvel, Henricus Theodorus

(56) References cited:
- WO-A-89/06597
- DE-B- 1 080 506
- DE-B- 1 094 402
- DE-B- 1 290 706
- DE-C- 488 318
- DE-C- 518 347
- GB-A- 1 292 593
- US-A- 4 723 899
- US-A- 4 812 114
- PATENT ABSTRACTS OF JAPAN vol. 004 no. 128 (M-031) ,9 September 1980 & JP-A-55 087517 (HITACHI LTD) 2 July 1980,

## Description

The invention relates to an single-strip moulding apparatus in accordance with the preamble of claim 1.

Such a moulding apparatus is disclosed in US patent 4.723.899. This patent discloses a moulding apparatus for enclosing semi-conductor chips with resin. The mould is provided with recesses for receiving the lead frames and in addition cavities are arranged in the mould wherein measured quantities of moulding material can be placed. By supplying heat and exerting pressure in these cavities with plungers the moulding material becomes liquid, moves via channels to the recesses for receiving the lead frames and, curing there, encapsulates the lead frames. The plungers are carried by a holder which is vertically slidable in guide supports. Movement of the holder can for example be operated by hydraulic means. Such a moulding apparatus has the drawbacks in that it requires a very complex constructure, the moulding apparatus is difficult to operate in clean surroundings and that the moulding process is difficult to control.

The object of the invention is to provide a single-strip moulding apparatus which solves the drawbacks of the existing moulding apparatuses and which combines a simple construction with a relatively high production rate.

This is achieved according to the invention by providing a single-strip moulding apparatus according claim 1.

Particular embodiments of the invention are the subject of the dependent claims.

Driving has taken place to date in the usual manner with hydraulic means, which however entails various drawbacks. Hydraulic driving requires cooling and is not otherwise well compatible with the clean surroundings in which the process must take place. There has further been the drawback that there was no direct proportional relation between the exerted hydraulic pressure and/or the controlled volume flow of the hydraulic oil and the displacement speed of the plunger. The pressure-raising process was difficult to control. Using the electro-mechanical driving a direct relation is achieved between the action of the electromotor and the displacement speed of the plunger and/or the force to be exerted by the plunger on the moulding material by converting the rotation movement of the electromotor into a linear movement of the plunger rod using the nut and the screwed rod. An electromotor moreover does not pollute the surrounding area which befits the cleanliness required of the area wherein the process takes place. In addition the energy consumption of a hydraulic plunger drive is much greater than that of an electromechanical plunger drive. With hydraulic plunger driving cooling is therefore needed for the oil heated by friction losses. The noise level of an electromechanical driving is also considerably lower.

Japanse patent JP-A-55 087517 discloses a method an apparatus for cleaning a resin-moulding mould. After the moulding process has taken place the upper and lower mould are separated from each other. A protective cover is moved between the mould to cover a moulded product positioned in the opening. Following up this movement cleaners are placed between the mould halves to clean the inside surfaces of the mould.

The International patent application WO-A-89/06597 discloses an electric powder moulding machine to mould an object by compressing powder in a die, an upper punch and a lower punch. Both the punches are movable relative to the die. By moving the punches a powdered material is packed in a space provided by the die and punches. A driving mechanism is provided having upper and lower driving parts for operatively connecting the punches to a servo motor.

The plunger increasing the pressure in a cavity is preferably under bias. It is hereby possible to raise the pressure to the required level despite the fact that the same quantity of moulding material will not always be present in the relevant cavity. The position of the plunger is therefore adapted by the bias to the volume of moulding material in the relevant cavity. As alternative method a channel is arranged in one of the two mould halves which mutually connects the cavities into which the measured quantities of moulding material are fed, with the object of equalising mutual volume-differences in these fed quantities of moulding material.

The invention will be further elucidated with reference to the drawings.

In the drawings:
figures 1-3 show schematically one complete cycle of the moulding apparatus according to the invention;
figure 4 shows a perspective view of the moulding apparatus according to the invention;
figure 5 shows on a larger scale a detail of the lowermost part of the moulding apparatus according to figure 4;
figure 6 shows a sectional view of the mould of the moulding apparatus from figures 4 and 5;
figure 7 shows a first alternative embodiment of the closing mechanism of the mould of the moulding apparatus according to the invention; and
figure 8 shows a second alternative embodiment of the closing mechanism of the mould of the moulding apparatus according to the invention.

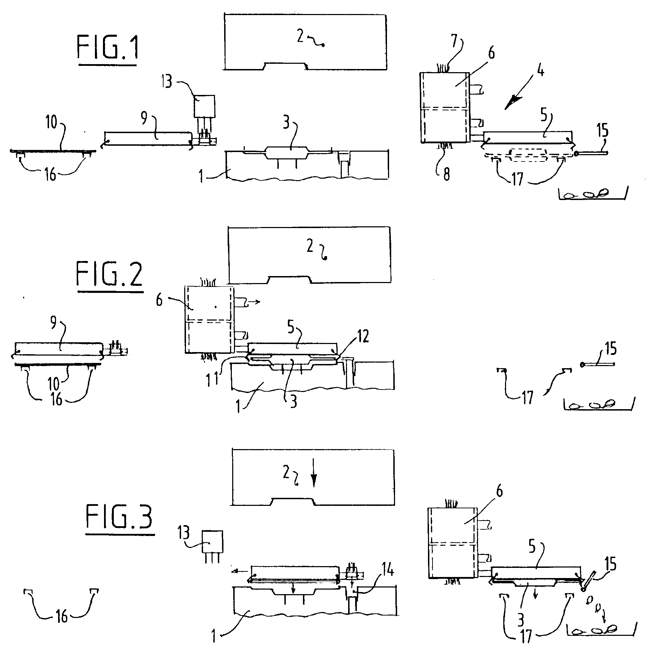

In figure 1 the mould, which consists of a fixedly positioned lower half and a vertically movable upper half, is open. It is assumed that the moulding has been completed during the previous cycle and that the moulded product 3 is still in the mould, that is, in the lower half 1. The cleaning-discharge unit 4 consists of a discharge carriage 5 and a brushing device 6 with brushes at the top 7 and brushes at the bottom 8. After opening of the mould (figure 1) the cleaning-discharge carriage 4 performs a movement to the left and thereby cleans the upper half of the mould (figure 2). The input carriage 9 likewise moves to the left to pick up a subsequent leadframe 10 from a store (not drawn) by means of a feed belt 16.

According to figure 2 the cleaning-discharge unit 4 then performs the return stroke wherein the discharge carriage 5 picks up the finished moulded frame 3 using schematically designated hook-shaped means 11, 12 and cleans the lower half of the mould.

Following on from the active stroke shown in figure 2 the input carriage 9 places the next leadframe into the mould. During the position in figure 1 the input carriage is thereby filled in cavities arranged for this purpose from a so-called pellet carriage 13 with pellet-shaped portions of moulding material which in the position as in figure 3 are placed into the cavities 14 intended for this purpose in the lower half 1 of the mould. The upper half 2 of the mould subsequently moves in the downward direction indicated with an arrow and closes (not drawn) onto the lower mould half, whereupon the moulding process begins. In the position drawn in figure 3 remnants of the moulding pellets are removed from the leadframe 3 with schematically designated means 15, after which the leadframe is discharged via a belt 17.

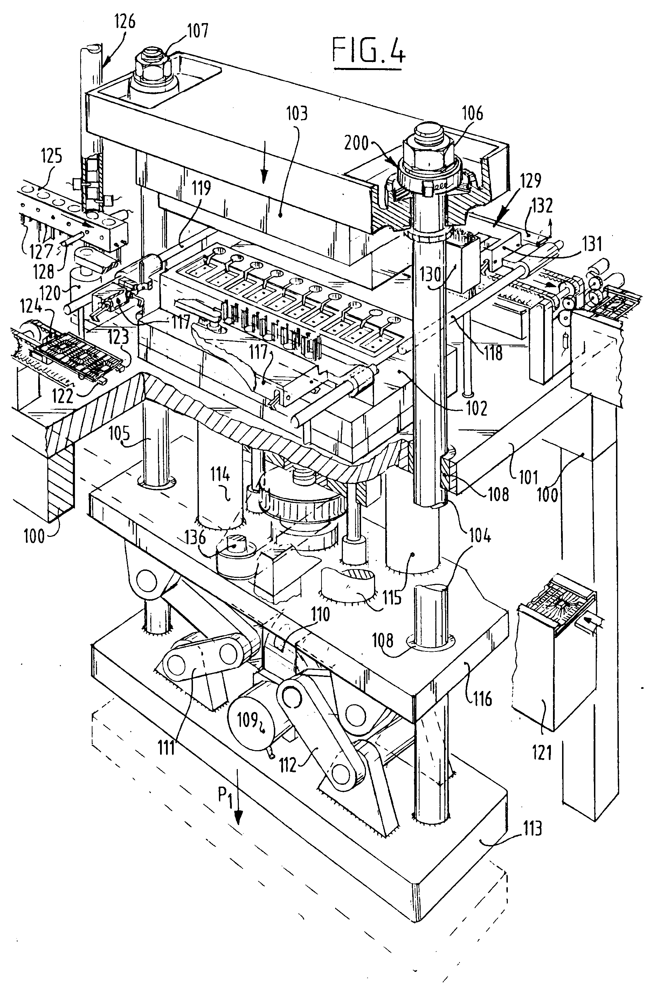

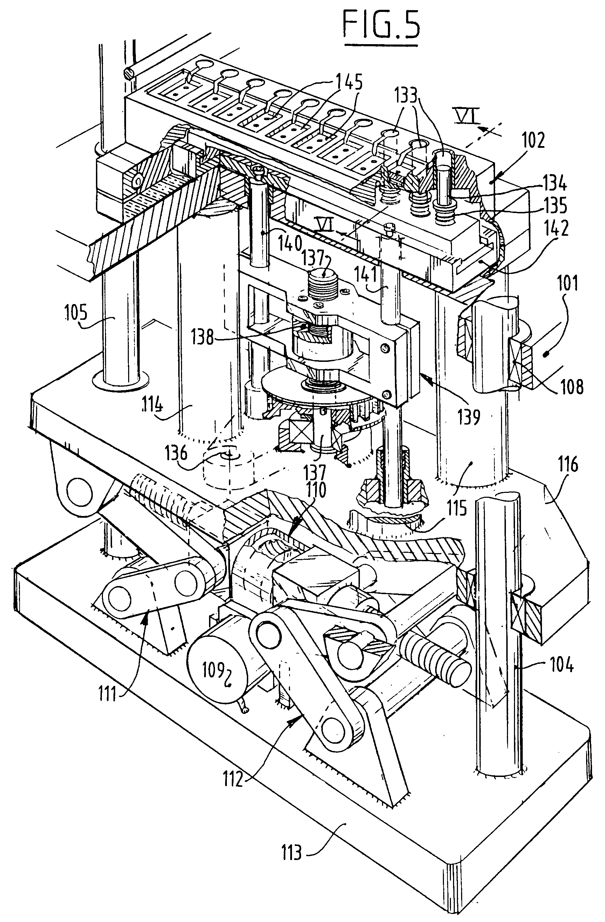

A further more detailed description will now be given with reference to figures 4 and 5.

Mounted on the frame 100 of the machine is a fixedly positioned table 101. The table 101 bears a fixed lower mould half 102. The upper mould half 103 is movable relative to the lower half 102 using pull rods 104, 105 which are connected to the upper half 103 by the respective nut connections, 106, 107. The pull rods 104, 105 are movable relative to the fixed table 101 via bearings, for example 108.

The driving of the upper half of the mould 103 takes place from an electromotor 109. Driven by means of the worm box 110 are the angle lever systems 111, 112. The angle lever systems are coupled on the one side to a movable underplate 113 and on the other side to a plate 116 fixedly connected to the table 101 by means of columns 114, 115. When the electromotor rotates the underplate 113 is moved vertically, for example in the direction of the arrow P1, which movement is transmitted via the pull rods 104, 105 onto the upper mould half 103. At the end of the stroke the arms of the angle lever system 111, 112 lie practically in one line so that a very great closing force is achieved.

The input carriage 117 is movable over the guide rails 118, 119. The driving of the input carriage 117 takes place from the electromotor 120.

Leadframes are supplied from a supply cassette and are carried up over the belts 122, 123 as far as a stop 124. During the position of the input carriage outside the mould the input carriage is filled from a so-called pellet-filling carriage 125 with pellet-shaped moulding material which is taken from a supply reservoir 126. For a reliable take-over of pellet-shaped moulding material by the input carriage 117 from the pellet transporting carriage 125 use is made in both carriages of pin-shaped guiding means 127. The mutual movements are controlled using a sensor 128.

The cleaning-discharge unit 129 is likewise movable over the rails 118, 119 between the position outside the mould die and the position inside the mould die. The unit 129 consists of a cleaning-brushing device 130 and a discharge member 131. The cleaning device 130 brushes both mould halves after use and simultaneously sucks up brushed-off remnants. Co-acting with the unit is a break-off plate 132 which subjects the finished product to an after-processing.

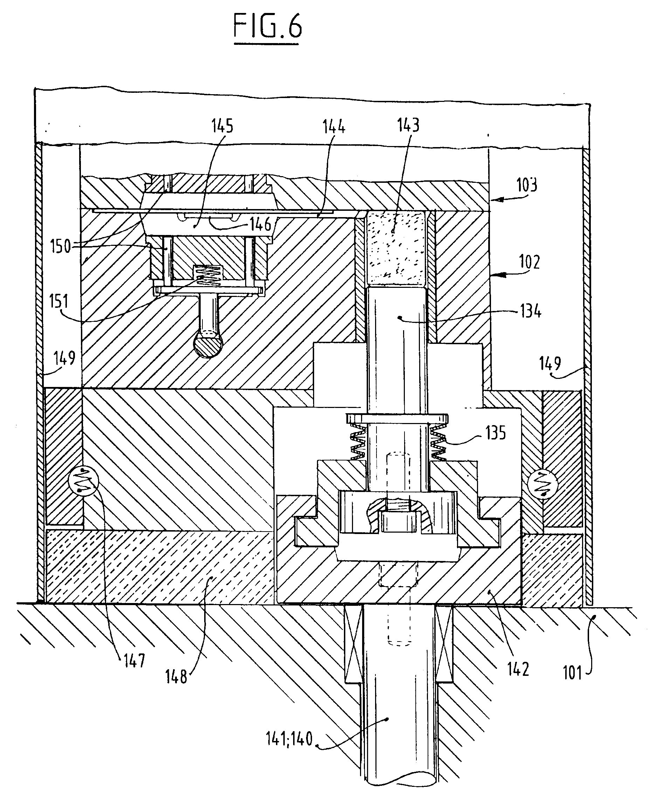

As can be seen in figure 5, the cavities 133 in the lower half 102 of the mould are each provided with a plunger 134 which (see also figure 6) is biased by a spring washer 135 such that the position of the plunger is adapted to the quantity of moulding material in the relevant cavities 133. The plungers are driven from an electromotor which drives a screwed rod 137 via the speed control 136. A nut 138 is placed on the screwed rod so that the rotating movement is converted into a vertically directed movement of the frame 139. Fixedly coupled to the frame are the drive rods 140, 141 for the plunger bracket 142 which in turn drives the plungers. As can be seen from the section VI-VI in figure 5 shown on a larger scale in figure 6, the pellet-shaped moulding material 143 is compressed during the ascending movement and transported via the channel 144 to the cavity 145 in the lower half of the mould where the chip 146 is arranged. As can be further seen in figure 6 a heating coil 147 is arranged for heating the lower half of the mould. The lower half of the mould is insulated by means of insulating material 148. Also visible in figure 6 is the protective cover 149.

In order to improve removal of the finished product a push-out pin 150 under bias of a spring 151 is arranged near the cavity 145.

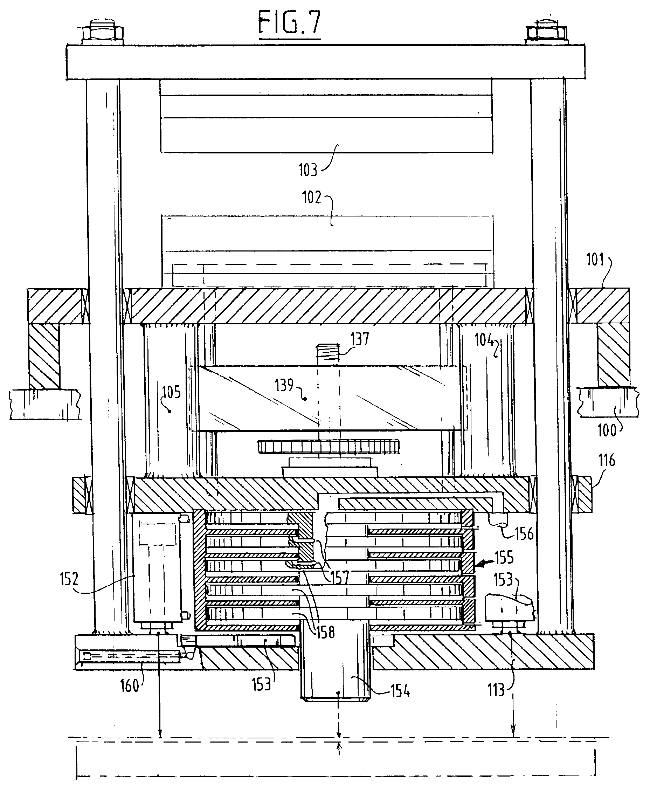

The embodiment according to figure 7 shows another embodiment for displacement of the upper half of the mould and the generating of the required great closing force.

Pneumatic cylinders 152 and 153 displace the upper half of the mould via the movable underplate 113, as in the case of the first discussed embodiment. At the end of the stroke the slide 153 is pushed under the piston rod 154 so that a closed piston-plunger 155 is created. Via the channel compressed air is subsequently admitted from a source 156 (not drawn) which is distributed via the sub-channels, for example 157, over pistons, for example 158, arranged on the piston rod 154. As a result of the large suction surface obtained by the combination of the pistons 158 arranged parallel on the rod 154 a very great closing force is achieved with a small stroke. This is transmitted to the plate 113 and therefore to the upper half of the mould 103. It is further noted that the closing of the slide takes place by means of the plunger 160.

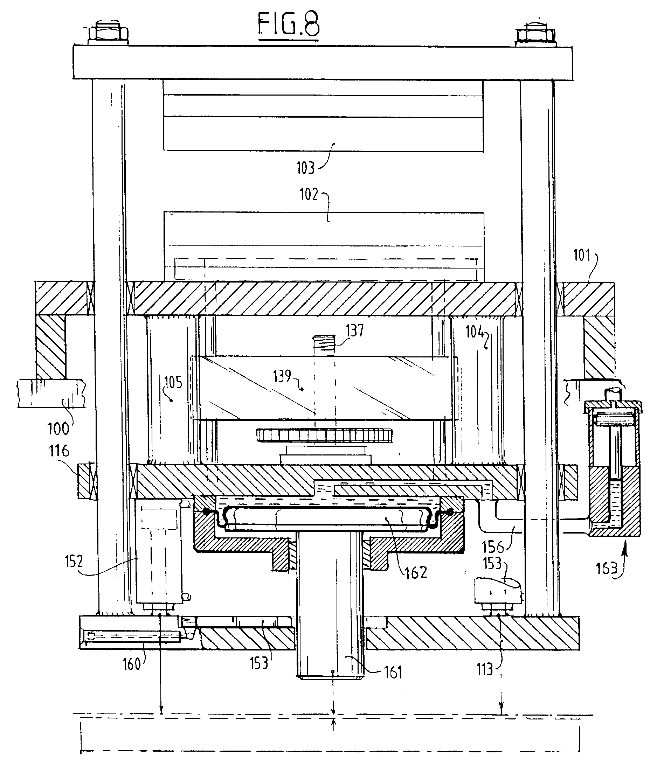

Figure 8 shows an alternative embodiment of the closing mechanism of the mould of the moulding apparatus according to the invention.

A discussion of those parts which correspond with the embodiment according to figure 7 is omitted.

The closing force of the mould halves is provided in this case by a piston-diaphragm cylinder unit filled with liquid. The plunger 161 is moved by the pressure of the liquid exerted on the piston 162, which is derived from the control cylinder 163. This is in contact with the cylinder space of the plunger 161 via the line 156.

## Claims

1. Single-strip moulding apparatus comprising a mould formed by two mould halves (1, 2, 102, 103) movable relative to one another and closable onto one another, means (134, 160, 161) for exerting pressure in cavities (14, 133) of the mould consisting of a plunger (134, 160, 161) and means (147) for heating the mould halves (1, 2, 102, 103), means (13, 117) for carrying moulding material (143) into cavities (14, 133) of the mould, and means (5, 131) for removing a moulded product (3) from the mould,
**characterized in that**
the apparatus also comprises means (9, 117) for placing a lead frame (10) into one of the mould halves (1, 2, 102, 103) and means (4, 129) for cleaning the mould halves (1, 2, 102, 103) and that the means (134, 160, 161) for exerting pressure consisting of a plunger (134, 160,161) are driven by an electromotor, a screwed rod (137) and a nut (138) arranged on the screwed rod (137).

2. Apparatus as claimed in claim 1, **characterized in that** each plunger (134, 160, 161) increasing the pressure in a cavity (14, 133) is under bias.

3. Apparatus as claimed in claims 1 or 2, **characterized in that** the plungers (134, 160, 161) increasing the pressure in the cavities (14, 133) are mutually connected by means of channels (156) in one of the mould halves (1, 2, 102, 103)

## Patentansprüche

1. Einzelband-Formvorrichtung, bestehend aus einer Form, die von zwei Formhälften (1, 2, 102, 103) gebildet wird, die relativ zueinander bewegt und aufeinander geschlossen werden können, Mitteln (134, 160, 161) zur Druckausübung in Hohlräumen (14, 133) der Form, die aus einem Druckkolben (134, 160, 161) und Mitteln (147) zum Heizen der Formhälften (1, 2, 102, 103) bestehen, Mitteln (13, 117) zum Transport von Formmasse (143) in Hohlräume (14, 133) der Form, und Mitteln (5, 131) zur Entfernung eines geformten Produktes (3) aus der Form,
dadurch gekennzeichnet, daß die Vorrichtung außerdem Mittel (9, 117) zum Legen eines Leiterrahmens (10) in eine der Formhälften (1, 2, 102, 103) und Mittel (4, 129) zur Reinigung der Formhälften (1, 2, 102, 103) umfaßt und daß die Mittel (134, 160, 161) zur Druckausübung, die aus einem Druckkolben (134, 160, 161) bestehen, von einem Elektromotor, einer Schraubenspindel (137) und einer auf der Schraubenspindel (137) angeordneten Mutter (138) angetrieben werden.

2. Vorrichtung nach Anspruch 1,
dadurch gekennzeichnet, daß jeder Druckkolben (134, 160, 161), der den Druck in einem Hohlraum (14, 133) erhöht, vorgespannt ist.

3. Vorrichtung nach Anspruch 1 oder 2,
dadurch gekennzeichnet, daß die Druckkolben (134, 160, 161), die den Druck in den Hohlräumen (14, 133) erhöhen, über Kanäle (156) in einer der Formhälften (1, 2, 102, 103) miteinander verbunden sind.

## Revendications

1. Appareil de moulage à démoulage unique comprenant un moule composé de deux parties de moule (1, 2, 102, 103) mobiles l'une par rapport à l'autre et pouvant être refermées l'une sur l'autre, des moyens (134, 160, 161) pour exercer une pression dans des cavités (14, 133) du moule comprenant un piston (134, 160, 161) et des moyens (147) pour chauffer les parties de moule (1, 2, 102, 103), des moyens (13, 117) pour introduire la matière à mouler (143) dans les cavités (14, 133) du moule, et des moyens (5, 131) pour retirer une pièce moulée (3) du moule,
**caractérisé en ce que**
l'appareil comprend également des moyens (9, 117) pour placer un ***grille*** ***de*** ***connexion*** (10) à l'intérieur d'une des parties de moule (1, 2, 102, 103) et des moyens (4, 129) pour nettoyer les parties de moule (1, 2, 102, 103) et en ce que les moyens (134, 160, 161) pour exercer la pression composés d'un piston (134, 160, 161) sont commandés par moteur électrique, une barre filetée (137) et un écrou (138) montés sur la barre filetée (137).

2. Appareil suivant la revendication 1, **caractérisé en ce que** chaque piston (134, 160, 161) augmentant la pression dans une cavité (14, 133) est ***sur*** ***pression******.***

3. Appareil suivant la revendication 1 ou 2, **caractérisé en ce que** les pistons (134, 160, 161) augmentant la pression dans les cavités (14, 133) communiquent mutuellement au moyen de canaux (156) dans une des parties de moule (1, 2, 102, 103).
